# EUROPEAN PATENT APPLICATION

(11) **EP 4 815 664 A1**
(43) Date of publication of application: **30.09.2026**
(21) Application number: 26315136.7
(22) Date of filing: 16.03.2026
(51) Int. Cl.: H10D 12/01, H10D 12/00, H10D 64/23, H10D 64/01, H10D 64/62

(54) **METHOD OF FORMING A RECESSED TERMINAL AND ELECTRONIC DEVICE INCLUDING THE RECESSED TERMINAL**

(30) Priority: 26.03.2025 IT 202500006270
(71) Applicant: STMicroelectronics International N.V., 1228 Plan-les-Ouates, Geneva (CH)
(72) Inventor: Mariani, Simone Dario, 20864 AGRATE BRIANZA (MB) (IT); Fagiani, Davide, 20864 AGRATE BRIANZA (MB) (IT); Gregoire, Magali, 38920 CROLLES (FR); Marchesi, Marco, 20864 AGRATE BRIANZA (MB) (IT); Estellon, Adrien, 38100 GRENOBLE (FR); Richet, Marina, 73000 CHAMBERY (FR)
(74) Representative: Studio Torta S.p.A.

(57) **Abstract**

An electronic device (100) comprising: a solid body (102; 104, 106) of semiconductor material including silicon, including a source region (106) and a body region (104); a trench (110) in the solid body (102; 104, 106), having a lateral wall (111; 110b) along the source region and a bottom wall (110c) along the body region; a first silicide region (116) in direct contact with the source region (106); a second silicide region (120) in direct contact with the body region (104). A first thickness (ts1') of the first silicide region (116) is different than a second thickness (ts2') of the second silicide region (120).

## Description

### TECHNICAL FIELD

The present invention relates to a method of forming an electrical contact of an electronic device, and to the electronic device.

### STATE OF THE ART

Insulated-Gate Bipolar Transistors (IGBTs), as well as other discrete power devices, typically use a trench-based design to narrow the cell dimension in the device portion housing the body and source regions.

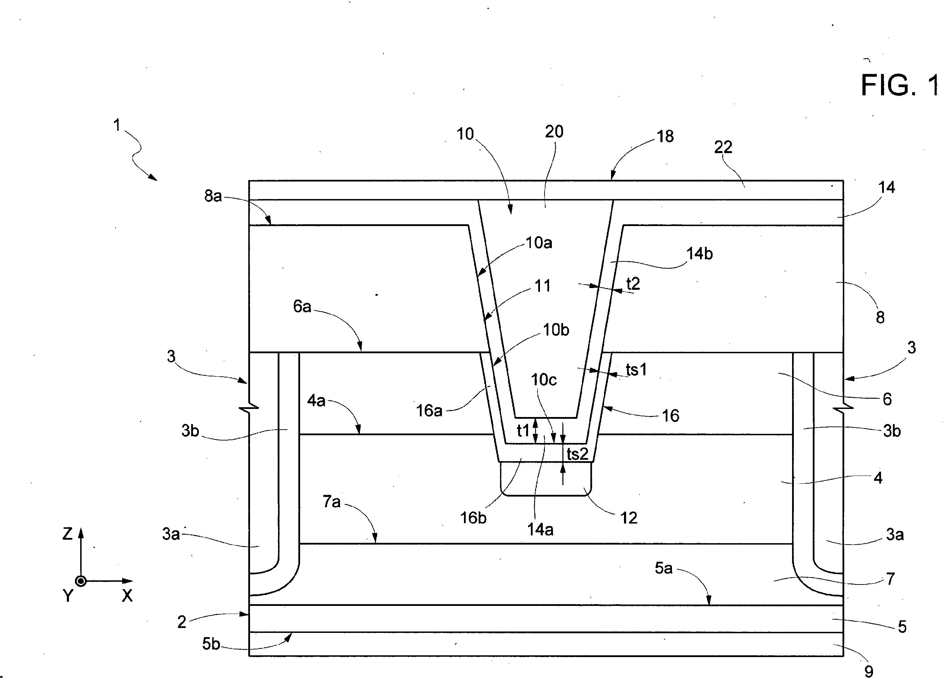

Figure 1 illustrates, in part, an electronic device 1, in particular an IGBT, of a type known to the Applicant, limited to a portion of the IGBT 1 comprised between gate terminals and including body and source regions. Figure 1 is illustrated in a triaxial system of axis X, Y, Z, orthogonal to each other, and is a lateral sectional view, on the XZ plane, of the IGBT 1.

Process steps to manufacture the portion of the IGBT 1 illustrated in Figure 1 are described in the following.

The IGBT 1 includes a semiconductive substrate 2 which in turn comprises a collector layer 5, a drift layer 7 extending on a first face 5a of the collector layer 5, and a body region 4 extending on a face 7a of the drift layer 7, opposite to the first face 5a of the collector layer 5 along the Z-axis. A backside metal contact 9 extends on a second surface 5b, opposite to the first surface 5a of the collector layer 5 along the Z-axis.

The semiconductive substrate 2 further comprises a source region 6, comprised between recessed gate terminals 3 (that is, the gate terminals 3 are formed in trenches within the substrate 2). The gate terminals 3 include, in a known way, a gate dielectric layer 3b and a gate conductive layer 3b. The source region 6 extends on a face 4a of the body region 4.

The semiconductive substrate 2 is made, for example, of silicon and can include one or more epitaxial layers.

The body region 4 is made of P-type doped silicon, with a first dopant concentration comprised between 1x10¹⁶ at/cm³ and 1x10¹⁸ at/cm³.

The source region 6 is made of N-type doped silicon, with a second dopant concentration comprised between 1x10¹⁹ at/cm³ and 1x10²⁰ at/cm³.

A dielectric layer 8 is deposited, for example by chemical vapor deposition, on a face 6a of the source region 6 opposite to the face 4a of the body region 4 along the Z-axis.

The dielectric layer 8 is made of silicon oxide (SiO₂) doped or undoped, or of aluminium oxide (Al₂O₃), or of a silicon nitride / silicon oxide stack, and it has a thickness, along the Z-axis, for example equal to 1 µm. The dielectric layer 8 has an upper surface 8a opposite to the face 6a of the source region 6 along the Z-axis.

A trench 10 is then formed, for example by lithographic and etching techniques, in the dielectric layer 8 at the upper surface 8a towards the semiconductive substrate 2. The trench 10 extends along the Z-axis completely through the dielectric layer 8, completely through the source region 6, and in depth in the body region 4, ending within the body region 4. The trench 10 has a depth along the Z-axis, for example of 0.3 µm, and has an extension parallel to the XY plane at the upper surface 8a for example of 0.3 µm.

The trench 10 has sidewalls 11 and a bottom surface 10c, the sidewalls 11 comprising a first portions 10a and a second portions 10b. The first portions 10a extends facing the dielectric layer 8 and form the interface between the trench 10 and the dielectric layer 8; the second portions 10b extends facing the source region 6 and form the interface between the trench 10 and the source region 6; the bottom surface 10c extends facing the body region 4 and form the interface between the trench and the body region 4.

After forming the trench 10, a body-contact region 12 (buried within the body region 4) is formed by ions implantation in the body region 4 at the bottom surface 10c of the trench 10. The body-contact region 12 extends in the body region 4 at a distance along the Z-axis from the bottom surface 10c of the trench 10. The body-contact region 12 is made of P-type doped silicon, with a third dopant concentration higher than the first dopant concentration and comprised between 1x10¹⁸ at/cm3 and 1x10²⁰ at/cm3.

A metal barrier layer 14 is then deposited in the trench 10 and on the upper surface 8a of the dielectric layer 8 by physical vapor deposition (PVD). The metal barrier layer 14 extends with physical continuity on the sidewalls 11 and on the bottom surface 10c of the trench 10.

The metal barrier layer 14 is a stack of different materials including a titanium (Ti) layer and titanium-nitride (TiN) layer, wherein the Ti layer is in direct physical contact with the dielectric layer 8 and the source region 6 at the sidewalls 11 and with the body region 4 at the bottom surface 10c of the trench 10.

In details, a first portion 14a of the metal barrier layer 14 extends in physical contact with the body region 4 at the bottom surface 10c and has a corresponding thickness t1 along the Z-axis comprised between 5 nm and 100 nm. Second portions 14b of the metal barrier layer 14 extend in physical contact with the dielectric layer 8 and the source region 6 at the sidewalls 11 and have, in respective directions orthogonal to the sidewalls 11, corresponding thicknesses t2 comprised between 5 nm and 100 nm. Due to intrinsic features of the PVD process exploited to form the metal barrier layer 14, the thickness t2 is lower than the thickness t1.

After depositing the metal barrier layer 14, a silicide region 16 is formed at the interface between the metal barrier layer 14 and the semiconductive substrate 2, for example by a thermal treatment at a temperature comprised between 450°C and 900°C for a time between 10 and 300 seconds.

In details, during the thermal treatment, Ti ions diffuse from the metal barrier layer 14 into the source region 6 and into the body region 4; at the same time, Si ions are diffusing in the opposite direction, in particular from the source region 6 into the metal barrier layer 14. Ti ions then react with Si ions respectively in the source region 6 and in the body region 4, forming a titanium-silicide material of the silicide region 16.

The silicide region 16 includes lateral portions 16a extending in the source region 6 at the second portions 10b of the sidewalls 11 and a bottom portion 16b extending at the bottom surface 10c of the trench 10, in the body region 4 and in direct electrical contact with the body-contact region 12.

Since the thickness t2 of second portions 14b is lower than the thickness t1 of the first portion 14a of the metal barrier layer 14, a lower number of Ti ions is available for the Ti-Si interdiffusion process in the second portions 14b compared to the number of Ti ions available for the Ti-Si interdiffusion process in the first portion 14a. As a result, the lateral portions 16a of the silicide region 16 are thinner than the bottom portion 16b of the silicide region 16.

In particular, the lateral portions 16a have a respective thickness ts1 in a direction orthogonal to sidewalls 11 comprised, for example, between 10nm and 200nm; the bottom portion 16b has a thickness ts2 in a direction parallel to the Z-axis comprised, for example, between 10nm and 200nm, with the thickness ts1 lower than the thickness ts2.

After forming the silicide region 16, a source metal contact 18 is formed in the trench 10 in a per se know manner, for example by successive steps of metal deposition and chemical mechanical polishing (CMP). In particular, the source metal contact 18 includes a metal filling layer 20 made of tungsten (W) or of copper (Cu) and extending in the trench 10 filling up completely the trench 10, and a metal contact layer 22 made of Al or Cu, and extending at least in part on the metal barrier layer 14 over the upper surface 8a of the dielectric layer 8 and on the metal filling layer 20, in electrical contact with the metal filling layer 20.

During the operation of the IGBT 1, a current flows from the source region 6 to the source metal contact 18 through the lateral portions 16a of the silicide region 16. At the same time, the body-contact region 12 is biased by the source metal contact 18 to a body voltage of the device through the bottom portion 16b of the silicide region 16.

The bottom portion 16b, while being necessary for the proper biasing of the body-contact region 12, introduces a mechanical stress between the semiconductive substrate 2 and the metal barrier layer 14. This mechanical stress may result in the formation of cracks in the metal barrier layer 14 and it increases with increasing the thickness ts2 of the bottom portion 16b.

In order to achieve a good ohmic contact between the source region 6 and the source metal contact 18 it is necessary to have thick lateral portions 16a of the silicide region 16, in particular thicker than 5nm. This can be achieved by increasing the thickness t2 of the second portions 14b of the metal barrier layer 14.

However, increasing the thickness t2 of the second portions 14b also increases, at the same time, the thickness t1 of the first portion 14a.

Therefore, increasing the thickness ts1 of the lateral portions 16a results in an increased thickness ts2 of the bottom portion 16b, which in turn leads to higher mechanical stress between the semiconductive substrate 2 and the metal barrier layer 14.

In order to overcome the above-mentioned limitations, chemical vapor deposition (CVD) may be used to deposit a metal barrier layer having an equal thickness on the bottom surface and on the sidewalls of the trench. However, also exploiting CVD to form the metal barrier layer, an increased thickness of the metal barrier layer on the sidewalls results in an increased thickness of the metal barrier layer on the bottom surface of the trench. Moreover, CVD processes are not commonly exploited for metal layers deposition in the fabrication of discrete device, resulting in increased fabrication costs.

For the above reasons, there is the need of providing alternative approaches for silicide regions manufacturing that produce lateral portions of the silicide region thicker than a bottom portion of the silicide region, while minimizing the mechanical stress between the semiconductive substrate and the metal barrier layer.

In general, there is the need for a manufacturing process that allows manufacturing a device where the lateral portions of the silicide region have a thickness different (and tuneable according to the design) from the corresponding thickness of a bottom portion of the silicide region.

### SUMMARY

According to the present invention, a method of forming an electrical contact of an electronic device and an electronic device are provided, as defined in the annexed claims.

### BRIEF DESCRIPTION OF THE DRAWINGS

For a better understanding of the present invention, preferred embodiments thereof will now be described purely by way of non-limiting example with reference to the appended drawings, wherein:
- Figure 1 illustrate, in lateral view, a portion of a IGBT device known to the Applicant; and
- Figures 2A-2H illustrate, in lateral view, manufacturing steps of a portion of an IGBT according to an embodiment of the present invention.

### DESCRIPTION OF PREFERRED EMBODIMENTS OF THE INVENTION

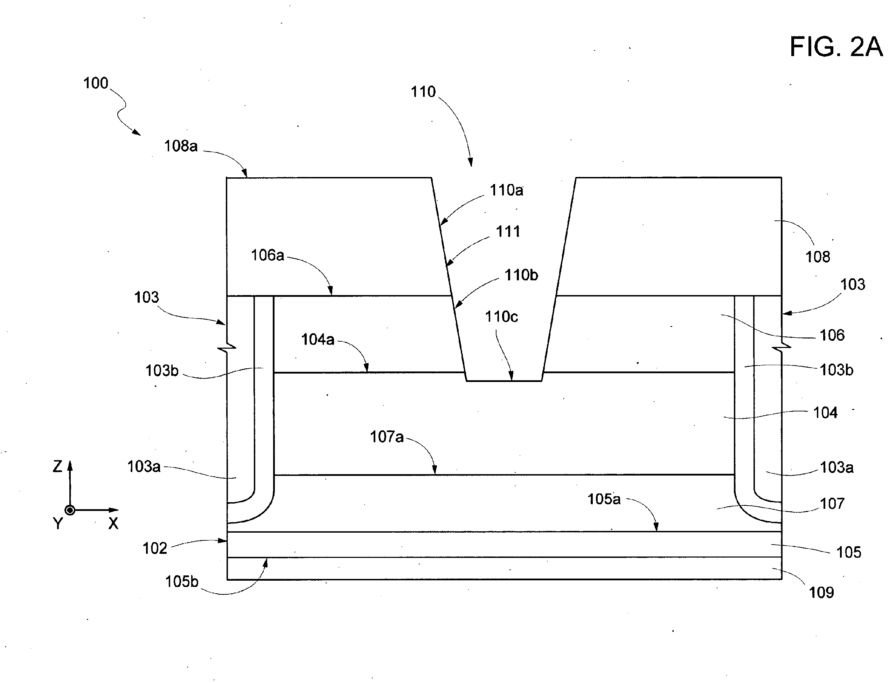

Figures 2A-2H illustrate, in lateral view, manufacturing steps of a portion of an electronic device 100, in particular an IGBT, limited to the features useful to understand the present invention. The view of figures 2A-2H is in a triaxial coordinate system of mutually orthogonal axes X, Y, Z, on the XZ plane.

In the following description, reference will be made to an IGBT device, without loosing generalization of the present invention, that can be applied to the manufacturing of a generic electronic device having one or more trench-based terminals.

With reference to Figure 2A, the IGBT 100 includes a semiconductive substrate 102. The semiconductive substrate 102 may include one or more epitaxial layers.

In particular, the semiconductive substrate 102 includes a collector layer 105, a drift layer 107 extending on a first face 105a of the collector layer 105, and a body region 104 extending on a face 107a of the drift layer 107, opposite to the first face 105a of the collector layer 105 along the Z-axis. A backside metal contact 109 extends on a second surface 105b, opposite to the first surface 105a along the Z-axis, of the collector layer 105.

The semiconductive substrate 102 further comprises a source region 106 extending on a face 104a of the body region 104 opposite, along the Z-axis, to the face 107a of the drift layer 107.

The semiconductive substrate 102 further comprises a first and a second gate region 103, extending in respective trenches within the semiconductive substrate 102 and delimiting the body region 104 and a source region 106. The first and a second gate region 103 have a respective gate dielectric layer 103a and a respective gate conductive layer 103b, in a per se known way. The portion of the IGBT 100 comprised between the first and the second gate region 103 is an emitter region of the IGBT 100.

The semiconductive substrate 102 is made for example of silicon or of silicon carbide.

The body region 104 has a first electrical conductivity, for example P-type, with a first dopant concentration comprised between 1x10¹⁶ at/cm3 and 1x10¹⁸ at/cm3.

The source region 106 has a second electrical conductivity opposite to the first electrical conductivity, for example N-type, with a second dopant concentration comprised between 1x10¹⁹ at/cm3 and 1x10²⁰ at/cm3.

The source region 106 has a thickness along the Z-axis comprised, for example, between 100nm and 500nm.

The IGBT 100 further includes a dielectric layer 108 extending on a face 106a of the source region 106 opposite to the face 104a of the body region 104 along the Z-axis.

The dielectric layer 108 is for example made of silicon oxide (SiO2) doped or undoped, or of aluminium oxide (Al2O3), or of a silicon nitride / silicon oxide stack, and it has a thickness, along the Z-axis, for example, between 0.5um and 2µm, in particular equal to 1µm. The dielectric layer 108 has an upper surface 108a opposite to the face 106a of the source region 106 along the Z-axis.

A trench 110 is formed in the dielectric layer 108 at the upper surface 108a towards the semiconductive substrate 102. The trench 110 extends with a main dimension along the Z-axis, completely through the dielectric layer 108 and completely through the source region 106, reaching the body region 104. In the embodiment illustrated in Figure 2A, the trench 110 extends in the body region 104 and ends within the body region 104.

In another embodiment (not illustrated), the trench 110 reaches the body region 104 exposing a portion of the face 104a of the body region 104 (that is, without penetrating within the body region).

The trench 110 has a dimension along the Z-axis comprised, for example, between 0.5µm and 3µm.

The trench 110 has sidewalls 111 and a bottom surface 110c. The sidewalls 111 extend with a main dimension transvers to the. XY plane, connecting the bottom surface 110c of the trench 110 with the upper surface 108a of the dielectric layer 108. The sidewalls 111 comprise first lateral portions 110a and second lateral portions 110b. At the first portions 110a, surfaces of the dielectric layer 108 are exposed; at the second portions 110b surfaces of the source region 106 are exposed; and, at the bottom surface 110c, surface the body region 104 is exposed.

The trench 110 is formed, for example, by lithography and etching steps, for example by dry etching such as Reactive Ion Etching (RIE) or Deep Reactive Ion Etching (DRIE), or alternatively by wet etching.

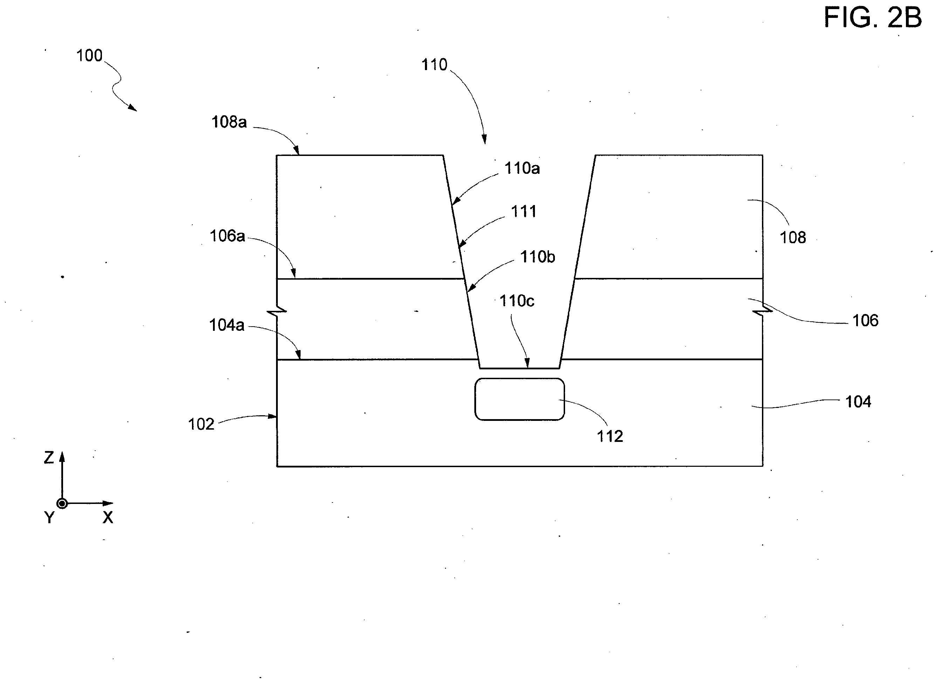

With reference to figure 2B, after forming the trench 110, a body-contact region 112 is optionally formed, for example by ions implantation, within the body region 104. In an embodiment, the body-contact region 112 is a buried region that extends in the body region 104 in correspondence of the bottom surface 110c of the trench 110, at a distance along the Z-axis from the bottom surface 110c of the trench 110. In another embodiment (not illustrated), the body-contact region 112 has a surface coplanar with, or adjacent to, the bottom surface 110c of the trench 110.

The body-contact region 112 has the first electrical conductivity, in particular P-type, with a third dopant concentration higher than the first dopant concentration and comprised between 1x10¹⁸ at/cm3 and 1x10²⁰ at/cm3.

The bottom surface 110c of the trench 110 is then etched to reach the body-contact region 112 in case the body-contact region 112 is not coplanar with the bottom surface 110c of the trench 110. A new bottom surface 110c of the trench 110 is thus formed, within the body-contact region 112.

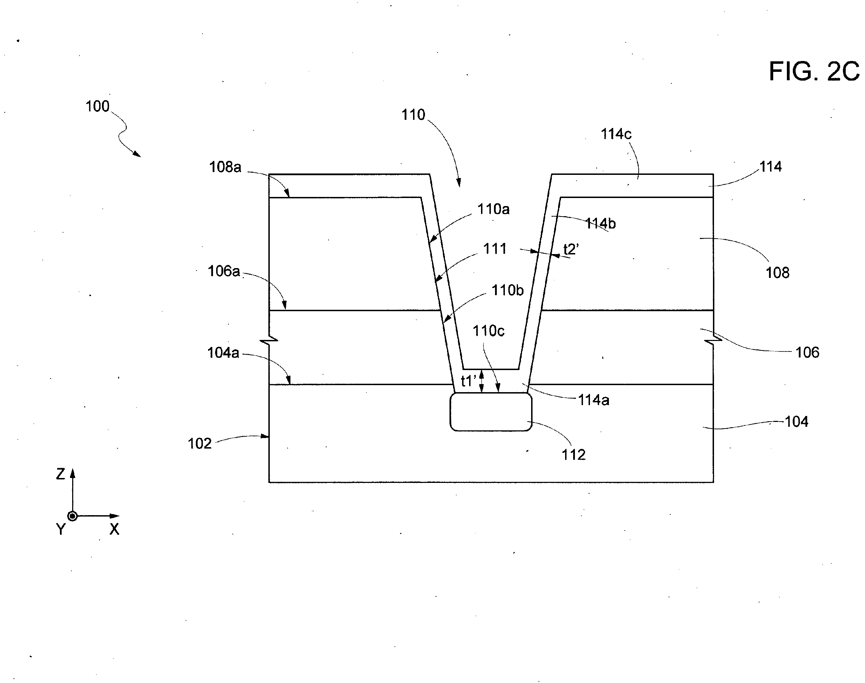

With reference to Figure 2C, a first metal layer 114 is deposited in the trench 110 and on the upper surface 108a of the dielectric layer 108 by physical vapor deposition. The first metal layer 114 extends with physical and electrical continuity on the sidewalls 111 and on the bottom surface 110c of the trench 110.

In an embodiment, the first metal layer 114 is made of, or includes, titanium (Ti) or titanium-nitride (TiN) or titanium-silicon (TiSi).

In another embodiment, the first metal layer 114 is a stack of layers of different metal materials including, for example, a Ti (or TiSi) layer and TiN layer, wherein the Ti (or TiSi) layer is in direct physical contact with the dielectric layer 108 and the source region 106 at the sidewalls 111 and with the body region 104 at the bottom surface 110c of the trench 110.

In details, a first portion 114a of the first metal layer 114 extends at the bottom surface 110c and has a corresponding thickness t1', along the Z-axis, comprised between 5 nm and 100 nm. Second portions 114b of the first metal layer 114 extend at the sidewalls 111 and have, orthogonally to the sidewalls 111, a thickness t2' lower than the thickness t1' and comprised between 5 nm and 100 nm. As consequence of the manufacturing process, third portions 114c of the first metal layer 114 extend on the upper surface 108a of the dielectric layer 108.

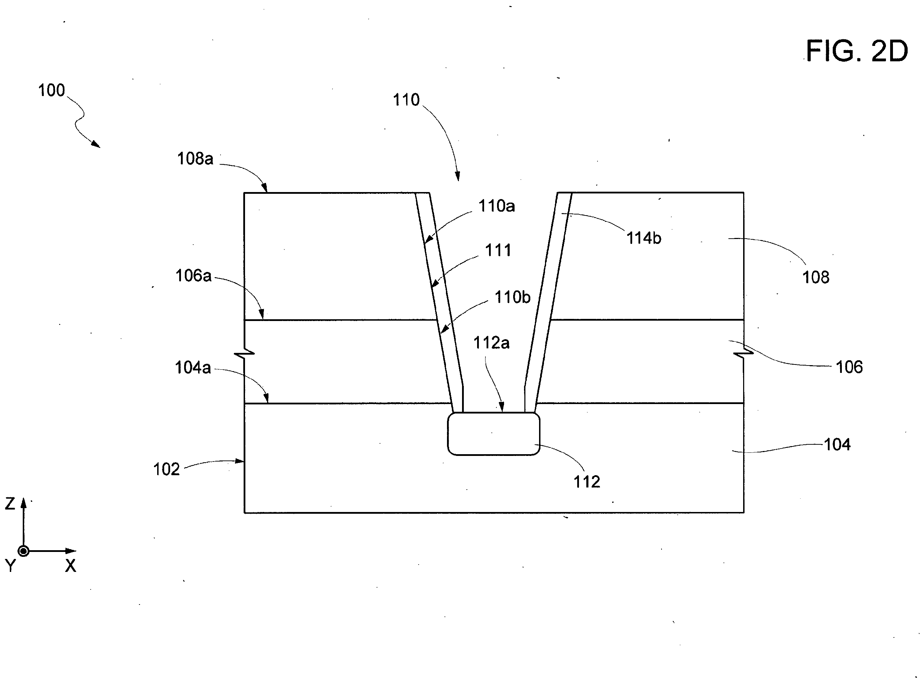

With reference to Figure 2D, an anisotropic etching is performed, configured to preferentially remove the portions of the first metal layer 114 parallel to the XY plane; accordingly, this etching step preferentially removes the first and the third portions 114a, 114c of the first metal layer 114, exposing a surface portion 112a of the body-contact region 112.

The anisotropic etching is performed for example by RIE or DRIE. In another embodiment, the anisotropic etching is performed by damaging the first portion 114a and the third portion 114c of the first metal layer 114 by ions implantation at high dose (for example with a dose equal to 1x10¹⁵) followed by a step of wet etching.

It is noted that, after the anisotropic dry etching of Figure 2D, the second portions 114b of the first metal layer 114 remain on the sidewalls 111 of the trench 110, in particular on the second portions 110b of the sidewalls 111.

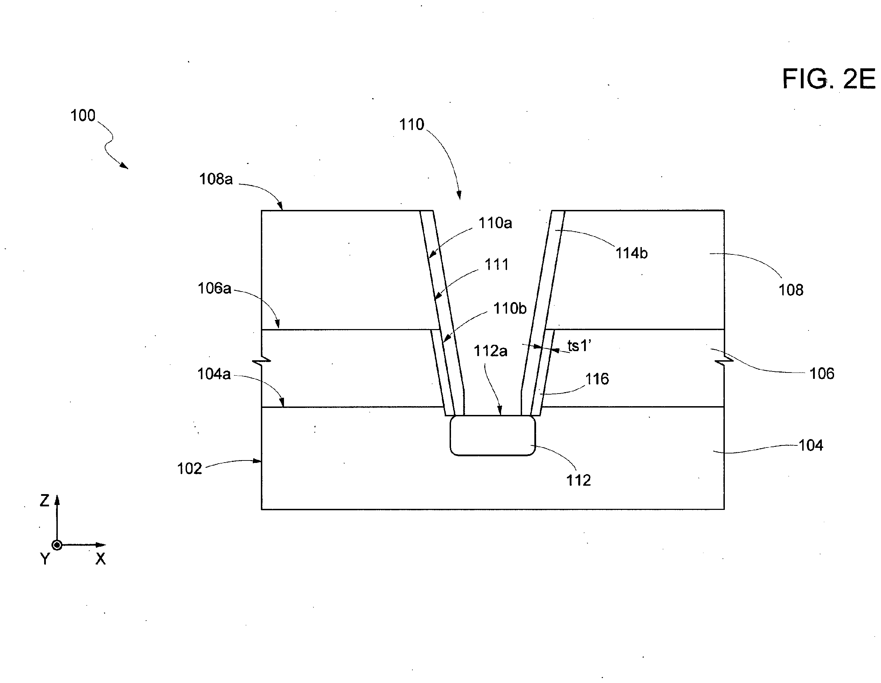

With reference to Figure 2E, a first thermal treatment is then performed at a first temperature T1 comprised, for example, between 600°C and 900°C, for a first time of 60 seconds, to form lateral silicide regions 116. In particular, during the first thermal treatment, Ti atoms diffuse from the second portion 114b of the first metal layer 114 into the source region 106 (and, in some embodiments, into the body region 104), and viceversa Si atoms diffuse from the source region 106 into the second portion 114b of the first metal layer 114. Ti ions then react with Si ions in the source region 106 (and, in some embodiments, in the body region 104) forming a titanium-silicide (TiSi / TiSi2) material of the vertical silicide region 116.

The lateral silicide regions 116 extend therefore in the source region 106, in particular in physical and electrical contact with the source region 106. The lateral silicide regions 116 have a thickness ts1', in a direction orthogonal to the sidewalls 111, comprised between 5nm and 200nm.

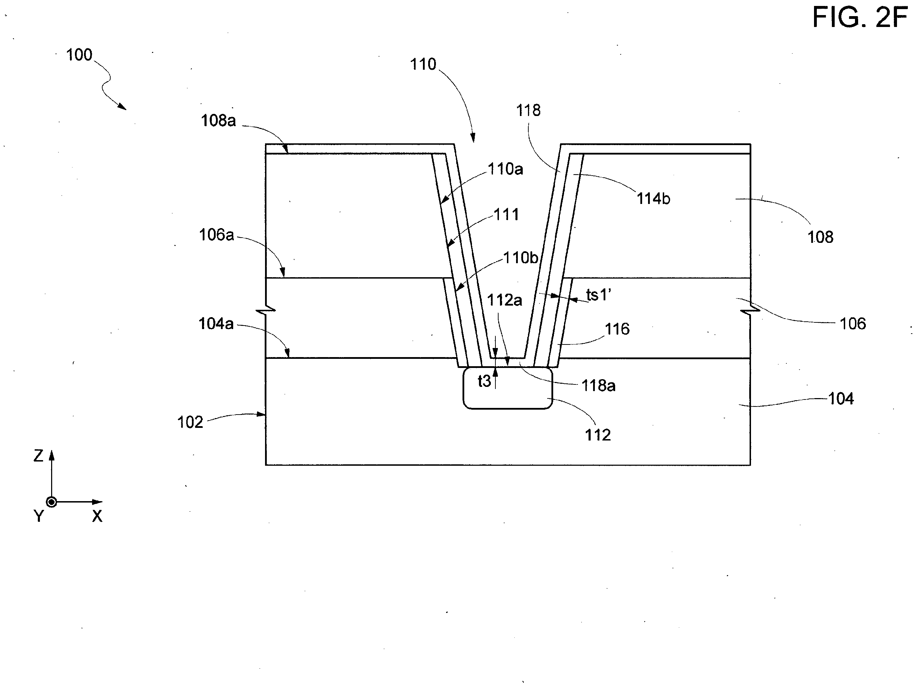

With reference to Figure 2F, a second metal layer 118 is then deposited, for example by physical vapor deposition (PVD), in the trench 110 and on the upper surface 108a of the dielectric layer 108.

The second metal layer 118 extends in the trench 110 with physical continuity on the second portions 114b of the first metal layer 114 and on the surface 112a of the body-contact region 112.

In detail, a portion 118a of the second metal layer 118 extends in direct physical contact with the surface 112a of the body-contact region 112, with a thickness t3 along a direction parallel to the Z-axis comprised between 5nm and 100nm, in particular equal to 20nm.

In an embodiment, the second metal layer 118 is made of, or includes, titanium (Ti) or titanium-nitride (TiN) or titanium-silicon (TiSi)

In another embodiment, the second metal layer 118 is a stack of layers of different materials including, for example, a Ti (or TiSi) layer and TiN layer, wherein the Ti (or TiSi) layer is in direct physical contact with the surface 112a of the body-contact region 112.

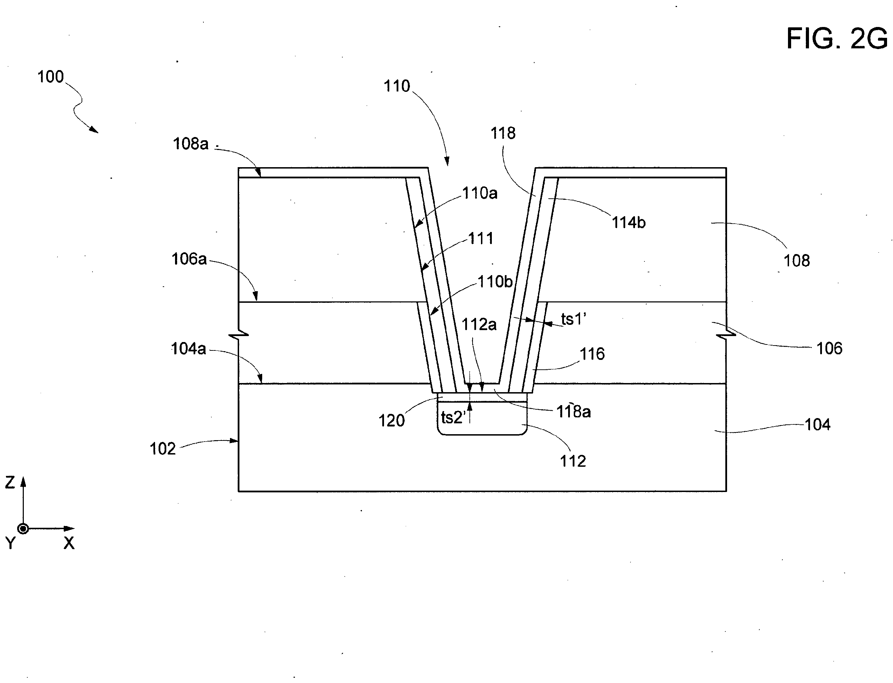

With reference to Figure 2G, a second thermal treatment is performed at a second temperature T2 comprised, for example, between 450°C and 800°C, for a second time of 60 seconds, to form a bottom silicide region 120.

The bottom silicide region 120 extends in the body-contact region 112 at the surface 112a, with a thickness ts2' along the Z-axis comprised between 5nm and 200nm.

In an embodiment, the thickness ts1' is different from the thickness ts2'.

In an embodiment, the thickness ts1' is greater than the thickness ts2', in particular the thickness ts1' is equal to 50 nm and the thickness ts2' is equal to 10 nm.

In another embodiment, the thickness ts2' is greater than the thickness ts1', in particular the thickness ts2' is equal to 50 nm and the thickness ts1' is equal to 10 nm.

In yet another embodiment, the thickness ts2' is equal to the thickness ts1'.

During the second thermal treatment, Ti atoms diffuse from the second portion 118a of the second metal layer 118 into the body-contact region 112, and viceversa Si atoms diffuse from the body-contact region 112 into second portion 118a of the second metal layer. Ti ions then react with Si ions in the body-contact region 112 forming a titanium-silicide (TiSi / TiSi2) material of the bottom silicide region 120.

In one embodiment, the second temperature T2 is lower than the first temperature T1, in order to obtain that the T2 process is not affecting the layer formed during T1 process. Therefore, by exploiting different temperatures to form the lateral silicide regions 116 and the bottom silicide region 120, it is possible to tune their respective thicknesses without introducing limitations on the thicknesses of the first metal layer 114 or of the second metal layer 118.

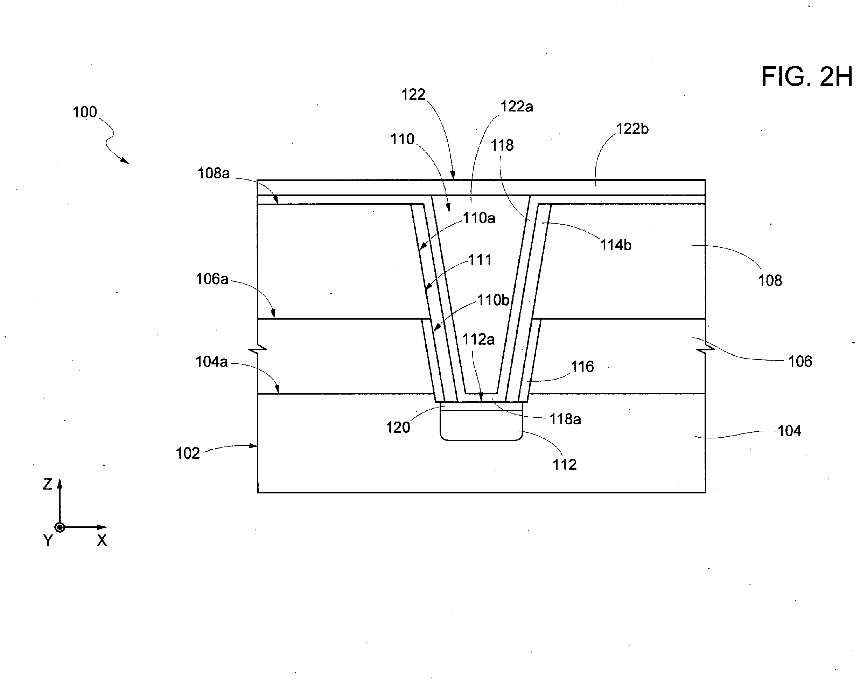

With reference to Figure 2H, after forming the bottom silicide region 120, a source metal contact 122 is formed in the trench 110 in a per se know manner, for example by successive steps of metal deposition and chemical mechanical polishing (CMP).

In particular, the source metal contact 122 includes a metal filling layer 122a extending in the trench 110, and (optionally) a metal contact layer 122b extending at least in part on the second metal layer 118 over the upper surface 108a of the dielectric layer 108, and on the metal filling layer 122a, in electrical contact with the metal filling layer 122a.

The metal filling 122a is made, for example, of tungsten (W) or of copper (Cu).

The metal contact layer 122b is made, for example, of Al or Cu.

From what has been described above, the advantages of the present invention emerge clearly.

In particular, forming the lateral silicide regions 116 and the bottom silicide region 120 respectively by ions diffusion from the first metal layer 114 in the first thermal treatment, and by ions diffusion from the second metal layer 118 in the second thermal treatment, allows obtaining thicker lateral silicide regions 116 compared to the bottom silicide region 120. Therefore, decoupling the formation of the vertical silicide region 116 from the formation of the bottom silicide region 120 allows increasing the thickness ts1' of the vertical silicide region 116 without increasing the mechanical stress introduced by the bottom silicide region 120 in the semiconductive substrate 102. In other words, it is possible to separately tune the thickness and phase of the vertical silicide region 116 with respect to the thickness and phase of the bottom silicide region 120.

Finally, it is clear that modifications and variations may be made to what has been described and illustrated herein without thereby departing from the scope of the present invention, as defined in the attached claims.

In particular, even though in the above description reference has been made to an IGBT, the present invention may be applied to other kind of electronic devices, for example, High Voltage discretes, Low Voltage discretes, BCD devices.

Moreover, in some embodiments, the first thermal treatment may be avoided, and the respective thicknesses and phase of the lateral silicide regions 116 and of the bottom silicide region 120 may be tuned by: depositing a first metal layer 114 thicker than the second metal layer 118; or by depositing a second metal layer 118 made of different materials with respect to the first metal layer 114; and performing a single thermal treatment after the deposition of the second metal layer 118.

## Claims

1. A method of forming an electrical contact of an electronic device, comprising the steps of:
- providing a solid body (102; 104, 106) of semiconductor material including silicon, the solid body comprising a first region (104) having a first electrical conductivity (P), a second region (106) having a second electrical conductivity (N) opposite to the first electrical conductivity (P) and extending on the first region (104);
- forming a trench (110) in the solid body (102; 104, 106), completely through the second region (106) and reaching the first region (104), the trench having a lateral wall (111; 110b) exposing the second region (106) and a bottom wall (110c) exposing the first region (104);
- forming a first metal layer (114) on the lateral wall (111; 110b) of the trench (110) and in direct contact with the second region (106), the first metal layer (114) being absent at least at a portion of the bottom wall (110c);
- forming a second metal layer (118) at said portion of the bottom wall (110c), in contact with the first region (104);
- forming, through one or more thermal treatments, a first silicide region (116) at the interface between the second region (106) and the first metal layer (114) and a second silicide region (120) at the interface between the first region (104) and the second metal layer (118).

2. The method of claim 1, wherein a first thickness (ts1') of the first silicide region (116) is different from a second thickness (ts2') of the second silicide region (120).

3. The method of claim 2, wherein the first thickness (ts1') of the first silicide region (116) is greater than the second thickness (ts2') of the second silicide region (120).

4. The method of anyone of the preceding claims, wherein:
forming the first silicide region (116) includes carry out a first thermal treatment at a first temperature (T1); and forming the second silicide region (120) includes carry out a first thermal treatment at a second temperature (T2) lower than the first temperature.

5. The method of claim 4, wherein the first temperature is in the range 600-900 and the second temperature is in the range 450-800

6. The method of anyone claims 1-3, wherein:
the first metal layer (114) has a first thickness (t2') and the second metal layer (118) has a second thickness (t3) lower than the first thickness (t2'); and
forming the first silicide region (116) and the second silicide region (120) includes carrying out a contextual thermal treatment.

7. The method of anyone of the preceding claims, wherein the first metal layer (114) is of a first metal material and the second metal layer (118) is of a second metal material, wherein the first metal material and the second metal material have respective coefficients of diffusion in the semiconductor material of the solid body (102) such that the coefficients of diffusion of the first metal material is greater than the coefficients of diffusion of the second metal material.

8. The method of anyone of the preceding claims, wherein the first metal layer (114) is of a first metal material from among: Ti or TiSi and TiN; and the second metal layer (118) is of a second metal' material having different thickness or composition from the first metal material, from among: Ti or TiSi and TiN.

9. The method of anyone of the preceding claims, wherein the step of forming the first metal layer (114) includes:
depositing the first metal layer (114) on the lateral wall and on the bottom wall of the trench; and
selectively removing the first metal layer (114) from said portion of the bottom wall.

10. The method of anyone of the preceding claims, further comprising the step of forming a buried region (112) in the first region (104) at the bottom wall (110c) of the trench (110), said buried region having the first electrical conductivity (P) and a doping concentration higher than a doping concentration of the first region (104),
wherein the step of forming the second metal layer (118) includes forming the second metal layer (118) in contact with the first region (104) through the buried region (112),
the second silicide region (120) extending at least in part within the buried region (112).

11. The method of anyone of the preceding claims, further comprising the step of forming a dielectric layer (108) on the second region (106), the step of forming the trench (110) comprising forming the trench (110) completely through the dielectric layer (108).

12. An electronic device (100) comprising:
- a solid body (102; 104, 106) of semiconductor material including silicon, the solid body including a first region (104) having a first electrical conductivity (P), and a second region (106) having a second electrical conductivity (N) opposite to the first electrical conductivity (P) and extending on the first region (104);
- a trench (110) in the solid body (102; 104, 106), extending completely through the second region (106) and reaching the first region (104), the trench having a lateral wall (111; 110b) along the second region (106) and a bottom wall (110c) along the first region (104);
- a first silicide region (116) extending between the second region (106) and the lateral wall (111; 110b), and in direct contact with the second region (106); and
- a second silicide region (120) extending between the first region (104) and the bottom wall (110c), and in direct contact with the first region (104),
wherein a first thickness (ts1') of the first silicide region (116) is different from a second thickness (ts2') of the second silicide region (120).

13. The electronic device (100) of claim 12, wherein the first thickness (ts1') of the first silicide region (116) is greater than the second thickness (ts2') of the second silicide region (120).

14. The electronic device (100) of claim 12 or 13, further comprising:
- a first metal layer (114) on the lateral wall (111; 110b) of the trench (110); and
- a second metal layer (118) on the bottom wall (110c) of the trench (110),
wherein the first silicide region (116) is between and in direct contact with the second region (106) and the first metal layer (114), and wherein the second silicide region (120) is between and in direct contact with the first region (104) and the second metal layer (118).

15. The electronic device of claim 14, wherein the first metal layer (114) is of a first metal material and the second metal layer (118) is of a second metal material, wherein the first metal material and the second metal material have respective coefficients of diffusion in the semiconductor material of the solid body (102) such that the coefficients of diffusion of the first metal material is greater than the coefficients of diffusion of the second metal material.

16. The electronic device of claim 14 or 15, wherein the first metal layer (114) is of a first metal material from among: Ti or TiSi and TiN; and the second metal layer (118) is of a second metal material having different thickness or composition from the first metal material, from among: Ti or TiSi and TiN.

17. The electronic device of anyone of claims 12-16, further comprising a buried region (112) in the first region (104) at the bottom wall (110c) of the trench (110), said buried region having the first electrical conductivity (P) and a doping concentration higher than a doping concentration of the first region (104),
wherein the second silicide region (120) extends at least in part within the buried region (112).

18. The electronic device of anyone of claims 12-17, wherein the electronic device (100) is an IGBT and further comprises a dielectric layer (108) on the second region (106), wherein:
the first region (104) is a body region of the electronic device (100);
the second region (106) is a source region of the electronic device (100);
the trench (110) extends completely through the dielectric layer (108); and
a third metal layer (122a) extends within the trench on the second metal layer (118) forming an emitter terminal of the electronic device.
